# EUROPEAN PATENT SPECIFICATION

(11) **EP 0 304 895 B1**
(45) Date of publication and mention of the grant of the patent: **20.10.1993**
(21) Application number: 88113798.8
(22) Date of filing: 24.08.1988
(51) Int. Cl.: C23C 14/34, C23C 14/40, H01L 21/30

(54) **Sputtering chamber structure for high-frequency bias sputtering process**
Kathodenzerstäubungskammervorrichtung für hochfrequenzversorgte Kathodenzerstäubung
Structure d'une chambre de pulvérisation cathodique pour pulvérisation cathodique en utilisant des hautes fréquences

(30) Priority: 26.08.1987 JP 211607/87
(43) Date of publication of application: 01.03.1989
(73) Proprietor: KABUSHIKI KAISHA TOSHIBA, Kawasaki-shi, Kanagawa-ken 210 (JP)
(72) Inventor: Katsura, Toshihiko Pat. Div., K.K. Toshiba, Minato-ku Tokyo 105 (JP); Abe, Masahiro Pat. Div., K.K. Toshiba, Minato-ku Tokyo 105 (JP)
(74) Representative: Henkel, Feiler, Hänzel & Partner

(56) References cited:
- US-A- 3 730 873
- PATENT ABSTRACTS OF JAPAN, unexamined applications, E section,vol. 8, no. 194, September 6,1984, THE PATENT OFFICE JAPANESE GOVERNMENT, page 11 E 264.

## Description

This invention relates to a semiconductor device manufacturing apparatus for forming an insulation film on a semiconductor substrate, and more particularly to a sputtering chamber structure for a high-frequency bias sputtering process for forming an insulation film.

In the multi-layered wiring process for the semiconductor device, an interlayer insulation film is formed by using a single wafer type high-frequency bias sputtering device, for example. The high-frequency sputtering device is used to effect the sputtering process for a semiconductor wafer substrate including one lot of partially fabricated semiconductor devices so as to form a relatively thick single insulation film as interlayer insulation films of the semiconductor devices. The sputtering process is effected by irradiating particles such as Ar⁺ ions to a target material and attaching particles emitted from the target material to a semiconductor wafer substrate placed on the opposite side thereof. In the process, Ar⁺ ions are also irradiated to the semiconductor substrate so that the substrate can have a smooth surface. In the recent bias sputtering device, a permanent magnet or electromagnet is provided on the rear side of the target plate and the distance between the semiconductor wafer substrate and the target plate is reduced to several tens mm so that the film formation speed can be enhanced.

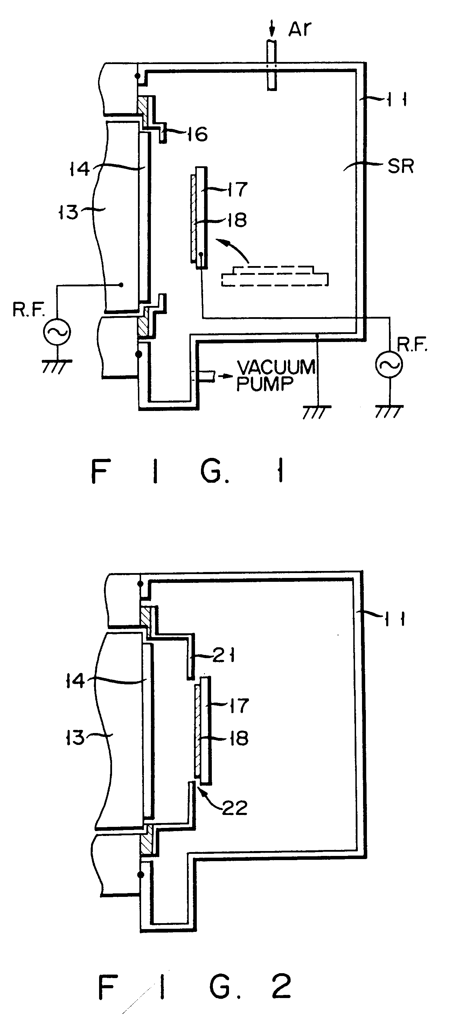

Fig. 1 is a cross sectional view showing the sputtering chamber structure of the conventional single wafer type high-frequency bias sputtering device dedicated to the formation of the insulation film. The sputtering device has target electrode 13 to which target 14 is attached. Semiconductor wafer substrate 18 is first fed to a position corresponding to target 14 in sputtering chamber SR, placed on substrate electrode 17 and then erected as shown by an arrow in Fig. 1. As a result, when substrate electrode 17 is disposed to face target 14, the surfaces of the substrate electrode and the target are set parallel with each other. After this, a first high-frequency power is applied between target electrode 13 and chamber wall 11, and a second high-frequency power is applied between substrate electrode 17 and chamber wall 11.

In the sputtering device, metal protection plate 16 is formed along the outer peripheral portion of target 14 in order to stop those sputtering particles which are not applied to semiconductor wafer substrate 18. However, metal protection plate 16 cannot prevent all of such particles, and it is impossible to prevent sputtering particles from being attached to chamber wall 11 of sputtering chamber SR.

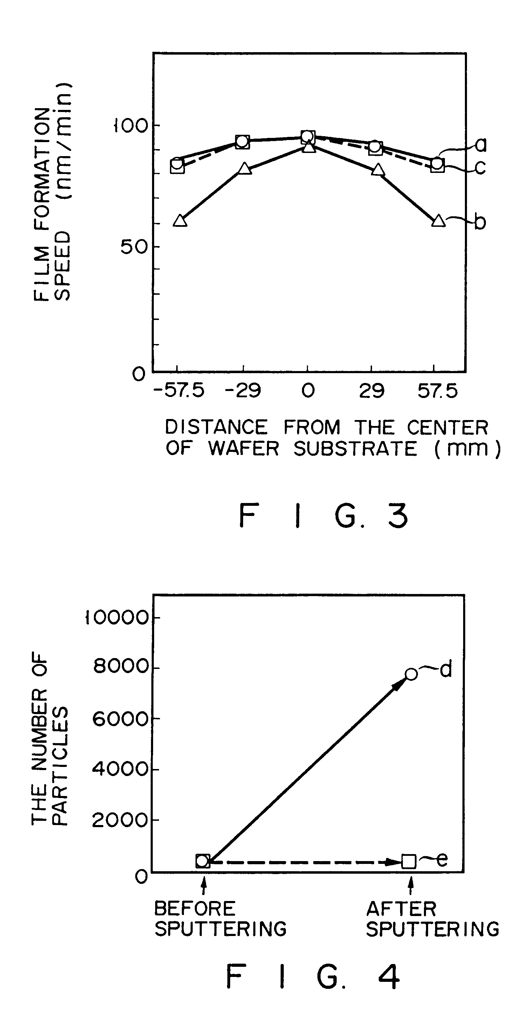

Fig. 2 shows an example in which metal protection plate 21 of the sputtering device shown in Fig. 1 is empirically modified. In this case, target 14 is surrounded by metal protection plate 21 having an opening in a portion facing target 14. The opening is substantially closed by means of substrate electrode 17 when semiconductor wafer substrate 18 is disposed to face target 14.

However, when metal protection plate 21 is used to prevent the sputtering particles from being attached to chamber wall 11 of sputtering chamber SR, plasma (for example, Ar ion) will be concentrated in gap 22 which is made between electrode 17 and metal protection plate 21. As a result, the sputter-etching speed in a partial area of semiconductor wafer substrate 18 at which plasma density is high is increased. For this reason, an insulation film formed on semiconductor wafer substrate 18 tends to have nonuniform thickness.

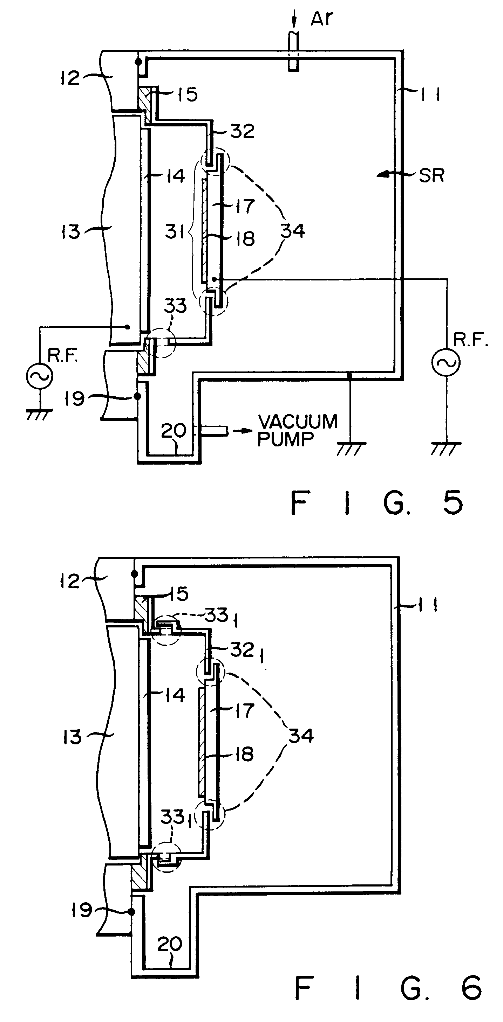

In a case where 12.7 cm (5-inch) substrate 18 is used and disposed at a distance of 60 mm from target 14 and at a distance of 5 mm from metal protection plate 21 having an opening of 140 mm diameter, an insulation film is formed on substrate 18 by effecting the sputtering process in the following condition: That is, Ar partial pressure is set at 0.30 pa, Ar flow rate is set at 30 SCCM, the target power is set at 3.0 kW, the substrate power is set at 0.5 kW, and a permanent magnet for generating a magnetic field having a field component in parallel with and near the surface of cathode plate 13 is used. Curve b in Fig. 3 shows the results of measuring the film formation speeds for each of that portions of semiconductor wafer substrate 18 which are spaced from the peripheral edge by more than 5 mm and are in one line extending across the center of substrate 18. In this case, the film formation speed is set to 80 nm/min, and the uniformity of the speed of sputtering for the substrate is detected to vary within a range of ±40% as shown by curve b in Fig. 3. Further, in case where metal protection plate 21 is not provided, the film formation speed and the uniformity of sputtering speed are set to 95 nm/min and ±5% as shown by curve a in Fig. 3. Thus, in this case, good uniformity can be obtained. 25 semiconductor substrates 18 are subjected to the film formation process for 10 minutes for each substrate in the same condition as described before without using protection plate 21. Then, another substrate 18 is horizontally carried in a reduced-pressure Ar atmosphere without effecting the film formation process.

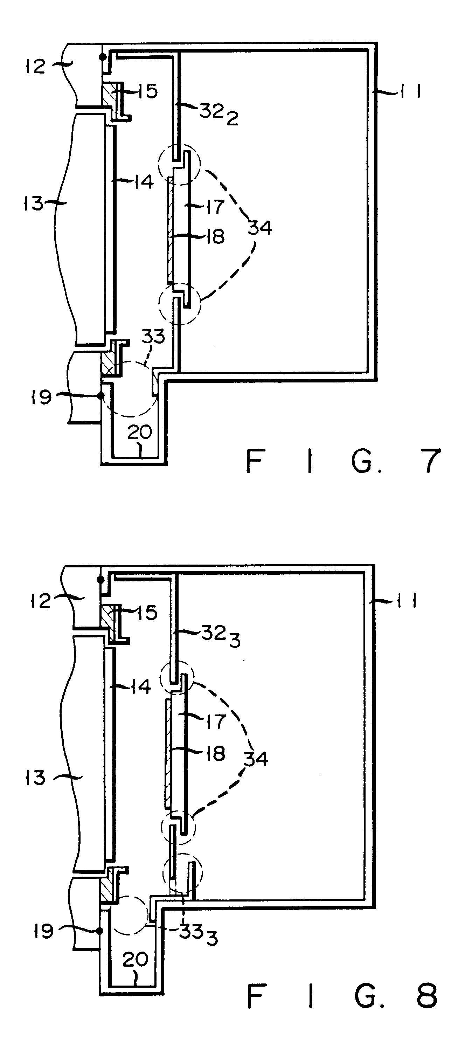

A particle check is effected thereafter. As shown by points d in Fig. 4, it is understood that approx. 8000 particles of 0.3 µm or more in diameter are attached to last substrate 18 as dust. The number is relatively large when considering that it was 60 before the film formation was effected. This is mainly because the sputtering film formed on chamber wall 11 is peeled off by temperature variation. If such a large number of particles are attached to substrate 18, the particles will enter into a film formed in the succeeding sputtering process. Therefore, decrease in the withstanding voltage, increase in the film leak, and short circuit in upper wiring layers may be caused and the reliability will be lowered.

An object of this invention is to provide a sputtering chamber structure which can prevent sputtering particles from being dispersed to various places other than a substrate without affecting uniformity in the thickness of a film formed by the high frequency bias sputtering process.

This object can be attained by a sputtering chamber structure comprising:
first and second electrodes to which the target and semiconductor substrate are attached, respectively;
a protection plate formed to surround the target and having a first opening facing the front surface of the target, the first opening being closed by the second electrode during the sputtering process, and a second opening section which is formed separately from the first opening so that plasma will not be concentrated at or near the edge portion of the semiconductor substrate when the high-frequency bias sputtering process is effected in a state that the first opening is closed by the second electrode; and
a chamber for receiving the first and second electrode and the protection plate and set in a reduced-pressure condition in the high-frequency bias sputtering process.

According to the above sputtering device, plasma can pass out via the second opening. Since the second opening is formed separately from the first opening, plasma will not be concentrated at or near the edge portion of the semiconductor wafer substrate. Further, particles can be prevented from falling from the top wall of the chamber down to the semiconductor wafer substrate by forming the second opening in a suitable position, for example, in a position below the protection plate.

This invention can be more fully understood from the following detailed description when taken in conjunction with the accompanying drawings, in which:
Fig. 1 is a cross sectional view showing the sputtering chamber structure of the conventional single wafer type high-frequency bias sputtering device;
Fig. 2 shows an example of the sputtering chamber structure in which a metal protection plate of the sputtering device shown in Fig. 1 is empirically modified;
Fig. 3 shows film formation speed characteristics in the conventional sputtering device;
Fig. 4 shows variation in the number of particles attached to the semiconductor wafer substrate in the reduced-pressure Ar atmosphere;
Fig. 5 is the sputtering chamber structure of a single wafer type high-frequency bias sputtering device according to one embodiment of this invention; and
Figs. 6 to 8 are modifications of the sputtering chamber structure of Fig. 5 in which the protection plate is modified.

There will now be described an embodiment of the sputtering chamber structure of a high-frequency bias sputtering device according to one embodiment of this invention with reference to Fig. 5. In Fig. 5, portions which are the same as those of the conventional sputtering device are denoted by the same reference numerals. The sputtering device includes chamber wall 11, target flange 12 and backing plate or target electrode 13, and space defined by these elements is used as sputtering chamber SR. Target 14 is mounted on backing plate 13 and kept substantially vertical. Target earth shield 15 is mounted along the periphery of target 14. The sputtering device further includes groove 20 formed in the bottom portion of chamber SR, O-ring 19 provided between chamber 11 and flange 12 and domed metal protection plate 32 removably attached to target earth shield 15. A vacuum pump (not shown) is communicated with groove 20. O-ring 19 is used to keep the pressure in sputtering chamber 11 to a preset vacuum pressure. Target 14 is surrounded substantially entirely by metal protection plate 32. Protection plate 32 has opening 31 formed to face target 14 and opening 33 formed below target 14 and separately from opening 31. Opening 31 is formed to have a diameter slightly larger than semiconductor wafer substrate 18, and opening 33 is formed to have a diameter smaller than that of opening 31. Opening 31 is closed by substrate electrode 17 on which semiconductor wafer substrate 18 is put. Opening 33 is so formed that plasma can pass out from the space defined between substrate 18 and target 14 via opening 33, thus decentralizing the target power.

In order to prevent occurrence of a gap when opening 31 is closed by means of electrode 17 so as to dispose substrate 18 in parallel with target 14, stepped portion 34 is formed on electrode 17 to lap over the edge portion of protection plate 32.

In an embodiment of Fig. 6, target power decentralizing opening 33₁ is formed in a crooked configuration so as to prevent sputtering particles from being scattered to the outer spacing via opening 33₁. That is, a curved gap is formed in the mounting portion of protection plate 32₁. Plasma may be discharged via the gap to the exterior, but sputtering particles which tend to move straightly will be prevented from being discharged via the gap to the exterior.

In an embodiment of Fig. 7, protection plate 32₂ is mounted on chamber wall 11 and thus formed in the form of partition wall.

In an embodiment of Fig. 8, protection plate 32₃ is mounted on chamber wall 11 and thus formed in the form of partition wall. Further, a plurality of target power decentralizing openings 33₃ are formed in different positions.

Now, the embodiments are described more in detail. A high-frequency bias sputtering device was used with domed protection plate 32 fixed on target earth shield 15 to empirically form a film. In the sputtering device, target 14 and substrate 18 were disposed to face each other and set at an inclination angle of 3° with respect to the vertical plane at the time of film formation, the distance between target 14 and substrate 18 was set at 60 mm, the target material was high purity quartz, the target diameter was set at 250 mm, and the diameter of substrate electrode 17 was set at 160 mm. The inner diameter of protection plate 32 was set at 250 mm, the height was set at 60 mm, the diameter of the opening on the wafer substrate side was set at 170 mm, and stepped portion 34 was formed on the periphery of substrate electrode 17 to cover the gap formed between protection plate 32 and substrate electrode 17 (Fig. 5). The diameter of opening 33 was 10 mm × 100 mm, and opening 33 was formed below protection plate 32. Further, groove 20 with the width of 60 mm was formed in the bottom portion of the sputtering chamber, and groove 20 was connected to a vacuum pump (not shown).

The film formation process was effected for 25 pieces of wafer substrates 18 of 5 inches in a condition that Ar gas was introduced into the sputtering chamber after the pressure thereof was reduced to 1.0 × 10⁻⁴ pa, and then Ar partial pressure was set at 0.30 pa, Ar flow rate was set at 30 SCCM, the target power was set at 3.0 kW, the substrate power was set at 0.5 kW (with the use of a permanent magnet), and the sputtering time was set at 10 minutes.

The result is shown by curve c in Fig. 3. As is seen from Fig. 3, the uniformity of the film formation speed is considerably improved. Further, the number of particles peeled off from the sputtering chamber and put on substrate 18 was checked before and after the film formation process. The result was good as shown by broken lines e in Fig. 4.

In order to prevent sputtering particles from target 18 from reaching chamber wall 11, the target power decentralizing opening of protection plate 32 may be formed in an overlapped form as shown by opening 33₁ in Fig. 6. In this case, plasma may pass out via opening 33₁, but substantially the same effect can be obtained.

Further, in a case where the protection plate is formed in the form of a partition plate as shown by protection plates 32₂ and 32₃ in Figs. 7 and 8, the same effect can be obtained. A plurality of target power decentralizing openings 33₃ are provided as shown in Fig. 8, but if they are provided approx. 40 mm apart from wafer 18, the distribution of the film formation speed in the substrate will not be lowered by increase in the speed of sputter-etching for local portion of the insulation film on the substrate.

In this invention, preferable values of 94 nm/min and ±6% were obtained as the film formation speed and the uniformity (Vmax-Vmin)/(Vmax+Vmin)(Vmax is the maximum deposition speed and Vmin is the minimum deposition speed) of the speed of sputtering for the substrate. Thus, the characteristics were significantly improved in comparison with characteristic curve b in Fig. 3. Further, the number of particles which had a diameter larger than 0.3 µm and were dropped onto substrate 18 by feeding substrate 18 in the reduced-pressure Ar atmosphere was checked before and after the film formation process. The number of particles was changed from 60 for each substrate (before the film formation process) to 214 for each substrate (after the film formation process). That is, increase in the number of particles due to the film formation process can be significantly suppressed (Fig. 4). Further, in the embodiments of Figs. 6 to 8, it was determined that the same effect can be attained.

In a case where a protection plate having no target power decentralizing opening is used and a film is formed on the substrate on which Aℓ-Si wiring layers are formed, the target power decentralizing effect cannot be attained and the Aℓ-Si wiring layer may be decomposed or changed in quality by temperature rise due to the concentration of plasma in the peripheral portion of the substrate, thus deteriorating the quantity of the semiconductor device. For this reason, it is necessary to use opening 33.

As described above, according to this invention, the second opening is formed in the protection plate and the peripheral portion of the protection plate defining the first opening is partly overlapped on the outer peripheral portion of the substrate electrode so that plasma can be prevented from being leaked out via the gap between the substrate electrode and the protection plate. Therefore, the sputtering speed can be made uniform, permitting an insulation film to be formed with an uniform thickness on the entire portion of the substrate. Further, since sputtering particles can be reliably blocked by means of the protection plate, they will not be attached to the inner wall of the sputtering chamber. Thus, occurrence of particles due to peel-off or separation of a film formed on the inner wall of the sputtering chamber can be prevented. The insulation film can be formed on any part inside the space defined by the protection plate, and the sputtering film thus formed can be prevented from being peeled off by adequately selecting the material of the protection plate surface and the electrode surface. For example, the electrode surface and the protection plate can be formed of quartz (SiO₂) for this purpose. Thus, particles can be sufficiently prevented from being attached to the substrate and entering into the sputtering film in the space defined by means of the protection plate.

Further, since the protection plate can be replaced, the maintenance therefore can be easily effected in comparison with the operation of cleaning the inner wall of the sputtering chamber.

## Claims

1. A sputtering chamber structure for a high-frequency bias sputtering process for forming an insulation film on a semiconductor substrate (18) by attaching particles emitted from a target (14) formed of insulative material, comprising:
first and second electrodes (13, 17) to which the target (14) and semiconductor substrate (18) are attached, respectively,
a protection plate (32) formed to surround said target (14) and having a first opening (31) facing the front surface of said target (14), said first opening (31) being closed by said second electrode (17) during said sputtering process, and
a chamber (SR) for receiving said first and second electrodes (13, 17) and said protection plate (32) and set in a reduced-pressure condition in said high-frequency bias sputtering process,
wherein said protection plate (32) further has a second opening section (33; 33₁; 33₃) which is formed separately from said first opening (31) so that plasma will not be concentrated at or near the edge portion of the semiconductor substrate when said high-frequency bias sputtering process is effected in a state that said first opening (31) is closed by said second electrode (17).

2. A sputtering chamber structure according to claim 1, characterized in that said second electrode (17) has a stepped portion (34) to lap over that edge portion of said protection plate (32) which defines said first opening (31).

3. A sputtering chamber structure according to claim 1 or 2, characterized in that said second opening section is divided into a plurality of openings (33₃).

4. A sputtering chamber structure according to claim 1, 2 or 3, characterized in that said second opening section is formed to have a curved gap (33₁) for discharging plasma from said inner space and blocking the particles emitted from said target (14).

5. A sputtering chamber structure according to claim 1 or 2, characterized in that said second opening section is formed at a position below said target (14).

## Patentansprüche

1. Kathodenzerstäubungskammeranordnung für einen Hochfrequenzvormagnetisierung-Kathodenzerstäubungsprozeß zur Erzeugung eines Isolierfilms auf einem Halbleitersubstrat (18) durch Anlagern von Teilchen, die von einem Target (14) aus Isoliermaterial emittiert werden, umfassend:
erste und zweite Elektroden (13, 17), an denen das Target (14) bzw. das Halbleitersubstrat (18) angebracht sind, eine das Target (14) umgebend geformte Schutzplatte (32) mit einer der Stirnfläche des Targets (14) zugewandten ersten Öffnung (31), die während des (Kathoden-)Zerstäubungsprozesses durch die zweite Elektrode (17) veschlossen ist, und eine zum Aufnehmen der ersten und zweiten Elektroden (13, 17) und der Schutzplatte (32) dienende Kammer (SR), die im Hochfrequenzvormagnetisierung-Zerstäubungsprozeß in einen Zustand reduzierten Drucks gesetzt ist,
wobei
die Schutzplatte (32) ferner einen von der ersten Öffnung (31) derart getrennt geformten Öffnungsteil (33; 33₁; 33₃) aufweist, daß sich Plasma nicht am oder nahe dem Randabschnitt des Halbleitersubstrats konzentriert, wenn der Hochfrequenzvormagnetisierung-Zerstäubungsvorgang in einem Zustand durchgeführt wird, in welchem die erste Öffnung (31) durch die zweite Elektrode (17) verschlossen ist.

2. Kathodenzerstäubungskammeranordnung nach Anspruch 1, dadurch gekennzeichnet, daß die zweite Elektrode (17) einen abgestuften Abschnitt (34) aufweist, welcher den die erste Öffnung festlegenden Randabschnitt der Schutzplatte (32) überlappt.

3. Kathodenzerstäubungskammeranordnung nach Anspruch 1 oder 2, dadurch gekennzeichnet, daß der zweite Öffnungsteil in eine Anzahl von Öffnungen (33₃) unterteilt ist.

4. Kathodenzerstäubungskammeranordnung nach Anspruch 1, 2 oder 3, dadurch gekennzeichnet, daß der zweite Öffnungsteil mit einem gekrümmten Spalt (33₁) zum Austragen oder Entlassen von Plasma und zum Blockieren der vom Target (14) emittierten Teilchen geformt ist.

5. Kathodenzerstäubungskammeranordnung nach Anspruch 1 oder 2, dadurch gekennzeichnet, daß der zweite Öffnungsteil in einer Position unterhalb des Targets (14) geformt ist.

## Revendications

1. Structure de chambre de pulvérisation pour un processus de pulvérisation à polarisation haute fréquence pour former un film d'isolation sur un substrat semiconducteur (18) en fixant des particules émises depuis une cible (14) réalisée en un matériau isolant, comprenant :
des première et seconde électrodes (13, 17) auxquelles la cible (14) et le substrat semiconducteur (18) sont respectivement fixés ;
une plaque de protection (32) formée de manière à entourer ladite cible (14) et comportant une première ouverture (31) qui fait face à la surface avant de ladite cible (14), ladite première ouverture (31) étant fermée par ladite seconde électrode (17) pendant ledit processus de pulvérisation ; et
une chambre (SR) pour recevoir lesdites première et seconde électrodes (13, 17) et ladite plaque de protection (32), laquelle chambre est établie dans une condition de pression réduite lors dudit processus de pulvérisation à polarisation haute fréquence,
dans laquelle :
ladite plaque de protection (32) comporte en outre une seconde section d'ouverture (33 ; 33₁ ; 33₃) qui est formée séparément de ladite première ouverture (31) de telle sorte que du plasma ne soit pas concentré au niveau de la partie de bord du substrat semiconducteur ou à proximité de celle-ci lorsque ledit processus de pulvérisation à polarisation haute fréquence est réalisé dans un état dans lequel ladite première ouverture (31) est fermée par ladite seconde électrode (17).

2. Structure de chambre de pulvérisation selon la revendication 1, caractérisée en ce que ladite seconde électrode (17) comporte une partie étagée (34) destinée à chevaucher la partie de bord de ladite plaque de protection (32) qui définit ladite première ouverture (31).

3. Structure de chambre de pulvérisation selon la revendication 1 ou 2, caractérisée en ce que ladite seconde section d'ouverture est divisée en une pluralité d'ouvertures (33₃).

4. Structure de chambre de pulvérisation selon la revendication 1, 2 ou 3, caractérisée en ce que ladite seconde section d'ouverture est formée de manière à présenter un espace incurvé (33₁) pour décharger du plasma depuis ledit espace interne et pour bloquer les particules émises depuis ladite cible (14).

5. Structure de chambre de pulvérisation selon la revendication 1 ou 2, caractérisée en ce que ladite seconde section d'ouverture est formée en une position qui se situe au-dessous de ladite cible (14).
